# EUROPEAN PATENT APPLICATION

(11) **EP 2 793 281 A1**
(43) Date of publication of application: **22.10.2014**
(21) Application number: 12858061.0
(22) Date of filing: 16.11.2012
(51) Int. Cl.: H01L 51/50, G02B 5/30, H05B 33/02, H05B 33/26

(54) **ORGANIC ELECTROLUMINESCENT ELEMENT**

(30) Priority: 13.12.2011 JP 2011271818
(71) Applicant: Panasonic Corporation, Kadoma-shi, Osaka 571-8501 (JP); Sumitomo Chemical Company, Limited, Tokyo 104-8260 (JP)
(72) Inventor: YAMANA, Masahito, Chuo-ku, Osaka 540-6207 (JP); NAKAMURA, Masahiro, Chuo-ku, Osaka 540-6207 (JP); YAMAKI, Takeyuki, Chuo-ku, Osaka 540-6207 (JP); KUWAHARA, Hajime, Niihama-shi, Ehime 792-0015 (JP); KAIHO, Akio, Niihama-shi, Ehime 792-0015 (JP)
(74) Representative: Appelt, Christian W.
(86) International application number: PCT/JP2012/079823
(87) International publication number: WO 2013/088904

(57) **Abstract**

The organic electroluminescent element includes: a substrate; a first electrode on a surface of the substrate; a second electrode opposite the first electrode; and a functional layer that is between the first electrode and the second electrode and includes at least a light emission layer. In this organic electroluminescent element, the first electrode is a metal electrode and also is a light-reflective electrode, the second electrode is a light-transmissive electrode, and thus light is allowed to emerge outside from the second electrode. The light emission layer is of a polymer material and has an in-plane direction and a thickness direction. A refractive index in the in-plane direction of the light emission layer is greater than a refractive index in the thickness direction of the light emission layer.

## Description

### Technical Field

The present invention relates to organic electroluminescent elements.

### Background Art

In the past, there has been proposed an organic electroluminescent element having a structure illustrated in FIG. 6 (JP 2007-294266 A: hereinafter referred to as Patent Literature 1).

This organic electroluminescent element includes a laminate on a surface of a transparent substrate 101. The laminate includes a low refractive index layer 111, a high refractive index layer 110, a transparent electrode 102, a hole injection layer 103, a hole transport layer 104, an organic light emission layer 105, an electron transport layer 106, an electron injection layer 107, and a metal electrode 108.

The organic electroluminescent element allows light to emerge from the transparent substrate 101. In this organic electroluminescent element, light that is emitted from the organic light emission layer 105 and travels toward the metal electrode 108 is reflected by a metal mirror 108a of the metal electrode 108, passes through the transparent electrode 102 and the transparent substrate 101, and finally emerges outside.

In this organic electroluminescent element, to improve a light-outcoupling efficiency, the high refractive index layer 110 and the low refractive index layer 111 are placed between the transparent electrode 102 and the transparent substrate 101 such that the high refractive index layer 110 and the low refractive index layer 111 are close to the transparent electrode 102 and the transparent substrate 101 respectively.

### Summary of Invention

### Technical Problem

Recently, in the field of organic electroluminescent elements, it has been known that reducing optical loss caused by surface plasmons occurring on surfaces of metal electrodes is important for improvement of the light-outcoupling efficiency. However, Patent Literature 1 does not explicitly mention the optical loss caused by the surface plasmons on the surface (metal mirror 108a) of the metal electrode 108.

In view of the above insufficiency, the present invention has aimed to propose an organic electroluminescent element having a simplified structure but having an improved light-outcoupling efficiency.

### Solution to Problem

The organic electroluminescent element in accordance with the present invention has an invert structure including: a first electrode of a metal electrode; a second electrode opposite the first electrode; and a functional layer that is between the first electrode and the second electrode and includes at least a light emission layer. The light emission layer is of a polymer material, and has an in-plane direction and a thickness direction, and a refractive index in the in-plane direction of the light emission layer being greater than a refractive index in the thickness direction of the light emission layer. The first electrode is a cathode, and the second electrode is an anode. The organic electroluminescent element having the invert structure is defined as an organic electroluminescent element having a structure in which a cathode, a functional layer including at least a light emission layer, and an anode are stacked in this order. In this regard, the cathode may be on a substrate, or the cathode may serve as the substrate.

According to a preferred aspect of this organic electroluminescent element, a ratio of the refractive index in the in-plane direction of the light emission layer to the refractive index in the thickness direction of the light emission layer is greater than 1.05.

According to a preferred aspect of this organic electroluminescent element, the ratio is 1.1 or more.

According to a preferred aspect of this organic electroluminescent element, the ratio is 1.2 or more.

According to a preferred aspect of this organic electroluminescent element, the ratio is 1.4 or more.

According to a preferred aspect of this organic electroluminescent element, the ratio is 2.5 or less.

According to a preferred aspect of this organic electroluminescent element, the metal electrode serves as a substrate supporting a laminate of the functional layer and the second electrode.

According to a preferred aspect of this organic electroluminescent element, the second electrode has a mesh shape.

Brief Description of Drawings

FIG. 1 is a schematic sectional view of the organic electroluminescent element of the first embodiment.
FIG. 2 is a graph showing the simulation result of the relation between the ratio of the refractive index in the in-plane direction of the light emission layer to the refractive index in the thickness direction of the light emission layer and the relative external quantum efficiency.
FIG. 3 is a schematic sectional view of the organic electroluminescent element of the second embodiment.
FIG. 4A is a schematic sectional view of the organic electroluminescent element of the third embodiment.
FIG. 4B is a plan view of the primary part of the organic electroluminescent element of the third embodiment.
FIG. 5 is a schematic sectional view of the organic electroluminescent element of the fourth embodiment.
FIG. 6 is a schematic sectional view of an instance of the organic electroluminescent element of the background art.

### Description of Embodiments

### (FIRST EMBODIMENT)

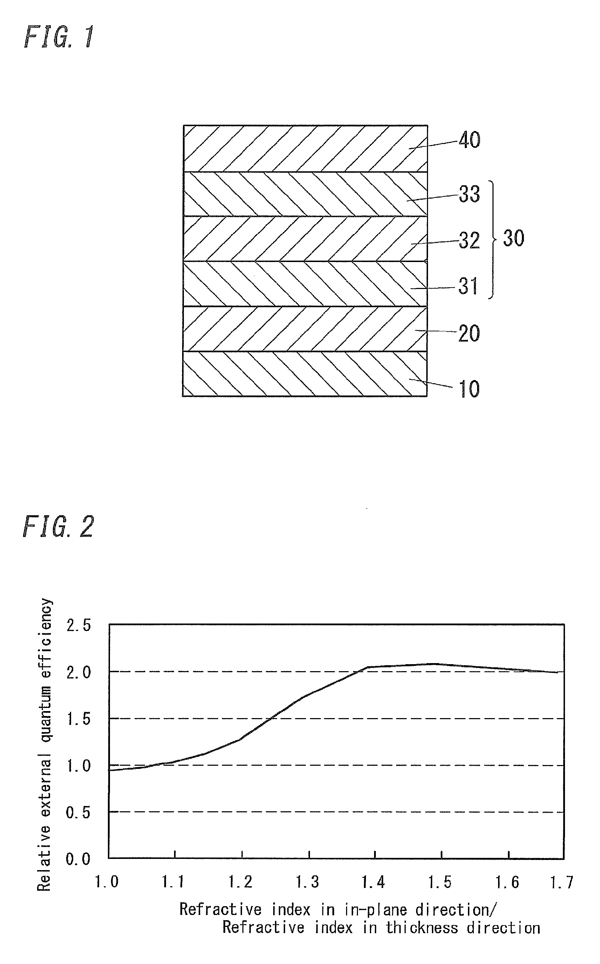

The organic electroluminescent element of the present embodiment is described hereinafter with reference to FIG. 1.

The organic electroluminescent element of the present embodiment is an organic electroluminescent element with an inverted structure.

The organic electroluminescent element includes a substrate 10, a first electrode 20, a second electrode 40, and a functional layer 30. The first electrode 20 is formed on a surface of the substrate 10. The second electrode 40 is opposite the first electrode 20. The functional layer 30 is between the first electrode 20 and the second electrode 40, and includes at least a light emission layer 31. In short, in this organic electroluminescent element, a laminate of the first electrode 20, the functional layer 30, and the second electrode 40 is on the surface of the substrate 10 that is on the opposite side of the functional layer 30 from the first electrode 20, and is supported by the substrate 10. In this organic electroluminescent element, the first electrode 20 is a metal electrode and also is a light-reflective electrode, the second electrode 40 is a light-transmissive electrode, and the organic electroluminescent element allows light to emerge outside from the second electrode 40.

The functional layer 30 includes the light emission layer 31, a hole transport layer 32, and a hole injection layer 33 which are arranged in this order from a side of the functional layer 30 close to the first electrode 20.

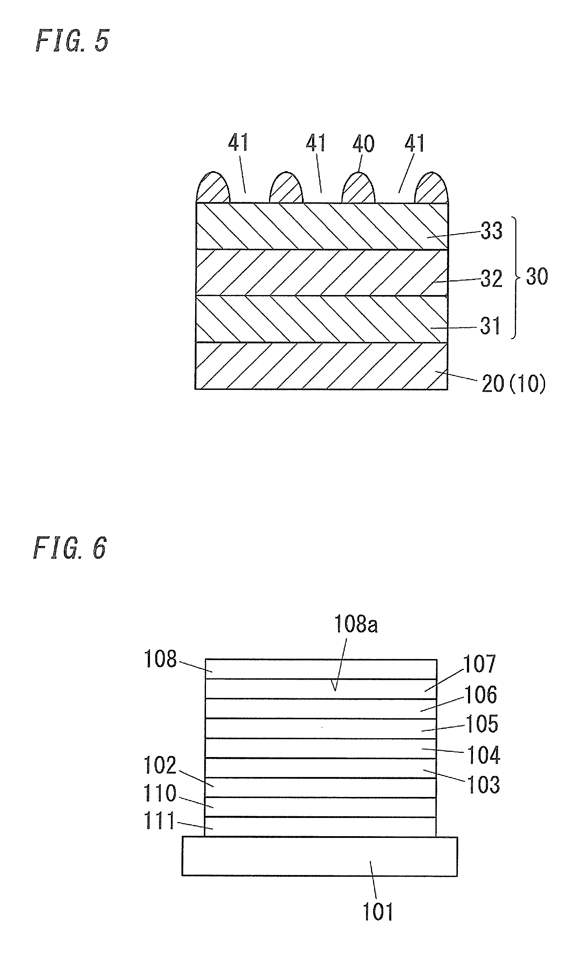

Patent Literature 1 discloses a method of manufacturing the organic electroluminescent element with the structure illustrated in FIG. 6. According to this method, first the transparent electrode 102 of an ITO thin film is formed on the surface of the transparent substrate 101 by DC magnetron sputtering, and subsequently the hole injection layer 103, the hole transport layer 104, the organic light emission layer 105, the electron transport layer 106, the electron injection layer 107, and the metal electrode 108 are formed in this order. Note that, the method of forming ITO thin films are not limited to the DC magnetron sputtering, but may be selected from various types of sputtering and deposition.

Recently, to reduce production cost, manufacture methods based on coating including roll-to-roll processing are attracting attentions of persons in the field of organic electroluminescent elements. The coating is suitable for a method of forming a transparent conductive film because the coating does not require expensive film formation apparatus such as sputtering equipment and deposition equipment and enables formation of the transparent conductive film with a lowered refractive index at a lowered cost. In the past, as there has been proposed a method of manufacturing a transparent plate including a transparent conductive film (e.g., JP 2009-181856 A). According to this method, a dispersion liquid prepared by dispersing electrically conductive wires in a dispersion medium is applied on a surface of a body of the transparent plate to form the conductive transparent film. However, the transparent conductive film formed in such a manner is greater in surface roughness than a transparent conductive film formed by sputtering or deposition. Hence, the former transparent conductive film is likely to cause a short circuit and a decrease in reliability of the organic electroluminescent element.

In contrast, according to the organic electroluminescent element of the present embodiment, the functional layer 30 is formed on a surface of the first electrode 20 of the metal electrode formed on the surface of the substrate 10, and the second electrode 40 which is light transmissive is formed on the opposite side of the functional layer 30 from the first electrode 20. In the organic electroluminescent element of the present embodiment, it is possible to improve smoothness of the surface of the first electrode 20 serving as a substrate for the functional layer 30, and, further, even if the first electrode 20 serving as a light transmissive electrode is formed by a wet process, it is possible to suppress the short circuit and the decrease in the reliability which would otherwise be caused by surface roughness of such a light transmissive electrode. Consequently, the production cost of the organic electroluminescent element of the present embodiment can be lowered and the reliability of the organic electroluminescent element of the present embodiment can be improved.

The substrate 10 may be of any material such as a glass substrate, a plastic plate, and, a metal plate, for example, but is not limited thereto. For example, the glass substrate may be of soda glass or non-alkali glass. For example, the plastic plate may be of polycarbonate or polyethylene terephthalate. For example, the metal plate may be of aluminum, copper, or, stainless steel. The substrate 10 may be rigid or flexible. When the substrate 10 is of the metal plate, the metal plate may be metal foil. Note that, to suppress the short circuit of the organic electroluminescent element, the smoothness of the surface of the substrate 10 seems to be very important. When the surface roughness of the surface of the substrate 10 is evaluated by an arithmetical average roughness Ra defined in JIS B 0601-2001 (ISO 4287-1997), the roughness Ra is preferably 10 nm or less, and is more preferably a few nm or less. According to this organic electroluminescent element, in the manufacture process, effects on the surface roughness of the surface of the first electrode 20 caused by the surface roughness of the surface of the substrate 10 can be reduced, and therefore the short circuit between the first electrode 20 and the second electrode 40 can be suppressed.

The first electrode 20 may serve as a cathode. Examples of material of the first electrode 20 may include metals such as aluminum and silver, and a compound containing at least one of these metals. Alternatively, the first electrode 20 may be a laminate of an aluminum thin layer and a thin layer of another electrode material such as a laminate of an alkali metal thin film and an aluminum thin film, a laminate of an alkali metal thin film and a silver thin film, a laminate of an alkali metal halide thin film and an aluminum thin film, a laminate of an alkali metal oxide thin film and an aluminum thin film, and a laminate of a thin film of alkaline-earth metal or rare-earth metal and an aluminum thin film, or be of an alloy of at least one of these metal species and other metal. Concrete examples include: a laminate of metal such as sodium, a sodium-potassium alloy, lithium, magnesium and an aluminum thin film; a laminate of a thin film of one of a magnesium-silver mixture, a magnesium-indium mixture, an aluminum-lithium mixture, and lithium fluoride, and an aluminum thin film; and a laminate of an aluminum thin film and an aluminum oxide thin film. Note that, it is preferable that the organic electroluminescent element include an electron injection layer that is between the first electrode 20 and the light emission layer 31 and promotes injection of electrons from the first electrode 20 to the light emission layer 31. The electron injection layer may be of the same material as the first electrode 20, or may be of metal oxide such as titanium oxide and zinc oxide, or an organic semiconductor material containing dopants for promoting electron injection, for example. However the material of the electron injection layer is not limited to the above materials.

A material of the light emission layer 31 is described below.

The hole transport layer 32 may be of low-molecular material or polymeric material having comparatively low LUMO (Lowest Unoccupied Molecular Orbital) level. Examples of material of the hole transport layer 32 include polymer containing aromatic amine such as polyarylene derivative containing aromatic amine on the side chain or the main chain, e.g., polyvinyl carbazole (PVCz), polypyridine, polyaniline and the like. However, the material of the hole transport layer is not limited thereto.

The hole injection layer 33 may be of organic material such as thiophene, triphenylmethane, hydrazoline, arylamine, hydrazone, stilbene, and triphenylamine. Concrete examples of materials of the hole injection layer 33 include aromatic amine derivative such as polyvinyl carbazole (PVCx), polyethylenedioxythiophene-polystyrenesulfonate (PEDOT-PSS), and N,N'-bis(3-methylphenyl)-(1,1'-biphenyl)-4,4'-diamine (TPD). One of these materials or a combination of two or more of these materials can be used.

The second electrode 40 may serve as an anode. For example, electrically conductive material for forming the second electrode 40 may be selected from silver, indium-tin oxide (ITO), indium-zinc oxide (IZO), tin oxide, fine particles of metal (e.g., gold), an electrically conductive polymer, an electrically conductive organic material, an organic material containing dopants (donors or acceptors), a mixture of a conductor and an electrically conductive organic material (including a polymer material), and a mixture of at least one of these electrically conductive materials and an insulator material. However, the electrically conductive material is not limited to the above examples. Examples of the insulator material may include acrylic resin, polyethylene, polypropylene, polyethylene terephthalate, polymethylmethacrylate, polystyrene, polyether sulfone, polyarylate, polycarbonate resin, polyurethane, polyacrylonitrile, polyvinyl acetal, polyamide, polyimide, diacryl phthalate resin, cellulosic resin, polyvinyl chloride, polyvinylidene chloride, polyvinyl acetate, other thermoplastic resin, and copolymer containing at least different two of monomers constituting the above-listed resin. Note that, the material of the organic binder is not limited thereto. Additionally, to improve electrical conductivity, the doping with the following dopant may be conducted. The dopant may be selected from sulfonic acid, Lewis acid, protonic acid, alkali metal, and alkaline-earth metal. However, the dopant is not limited to the above examples.

The light emission layer 31 is made of a polymer material. The light emission layer 31 has a refractive index in an in-plane direction thereof and a refractive index in a thickness direction thereof, and the refractive index in the in-plane direction of the light emission layer 31 is greater than the refractive index in the thickness direction of the light emission layer 31. With regard to the light emission layer 31, it is preferable that a ratio of the refractive index in the in-plane direction of the light emission layer 31 to the refractive index in the thickness direction of the light emission layer 31 be greater than 1.05 and be 2.5 or less. Each of the refractive indices of the light emission layer 31 may be determined with regard to light having a wavelength equal to an emission peak wavelength of the light emission layer 31.

As a structural model for evaluation of an external quantum efficiency, the present inventors used a laminate structure of the first electrode, the light emission layer, the hole injection layer, the second electrode, a matching oil, and a hemispherical lens as shown in the first column in TABLE 1. The present inventors set structural parameters (thicknesses) shown in the second column in TABLE 1 and optical parameters shown in the third and fourth columns in TABLE 1 to this structural model. The present inventors conducted simulation by use of the above structural model for a relation between a ratio of the refractive index in the in-plane direction of the light emission layer 31 to the refractive index in the thickness direction of the light emission layer 31 and the external quantum efficiency, and thus obtained results shown in TABLE 2. With regard to the item "Refractive index for light with wavelength of 530 nm" of the third column, the term "Anisotropy dependence" indicates a value selected from the refractive indices in the in-plane direction and the refractive indices in the thickness direction respectively shown in the first and second columns in TABLE 2.

**[TABLE 1]**

| | Thickness | Refractive index for light with wavelength of 530 nm | Extinction coefficient for light with wavelength of 530 nm |
|---|---|---|---|
| Hemispherical lens | infinity | 1.523 | 0 |
| Matching oil | 0 | | |
| Second electrode | 300 nm | 1.828 | 0.004 |
| Hole injection layer | 15 nm | 1.553 | 0 |
| Light emission layer | 80 nm | Anisotropy dependence | Anisotropy dependence |
| First electrode | 80 nm | 1.029 | 5.928 |

**[TABLE 2]**

| Refractive index in in-plane direction (wavelength of 530 nm) | Refractive index in thickness direction (wavelength of 530 nm) | Ratio of refractive index in in-plane direction to refractive index in thickness direction | Relative external quantum efficiency |
|---|---|---|---|
| 1.69 | 1.69 | 1.00 | 0.97 |
| 1.69 | 1.61 | 1.05 | 1.00 |
| 1.69 | 1.54 | 1.10 | 1.05 |
| 1.69 | 1.47 | 1.15 | 1.14 |
| 1.69 | 1.41 | 1.20 | 1.28 |
| 1.69 | 1.30 | 1.30 | 1.74 |
| 1.69 | 1.21 | 1.40 | 2.04 |
| 1.69 | 1.13 | 1.50 | 2.07 |
| 1.69 | 1.06 | 1.60 | 2.02 |
| 1.69 | 1.00 | 1.69 | 1.97 |

The above simulation was conducted with reference to reference document 1 (Georg Gaertner,et al, "Light extraction from OLEDs with (high) index matched glass substrates", Proc. of SPIE Vol.6999, 69992T1 to T12, 2008), reference document 2 (Ryo Naraoka, and two others, "Transfer phenomenon of excitation energy caused by surface plasmons", OLED discussion, the proceeding of the ninth regular meeting, S9-6, 2008), and reference document 3 (Akiyoshi Mikami, "Optical analysis of high-efficiency organic light-emitting device" OYO BUTURI, the Japan Society of Applied Physics, April, 2011, Vol. 80, No. 4, p277-283). Note that, the metal layer of reference document 3 is corresponding to the first electrode of the structural model. The laminated thin film of the reference document 3 is corresponding to the laminate of the light emission layer, the hole injection layer, and the second electrode of the structural model. Additionally, optical constants (the refractive indices and the extinction coefficient) are necessary for the simulation. In view of the anisotropy of the refractive index, the present inventors conducted analysis under the conditions where the refractive index in the in-plane direction is constant (1.69) and the refractive index in the thickness is variable. The refractive index in the in-plane direction and the refractive index in the thickness direction are determined for light with the wavelength of 530 nm. Further, the extinction coefficient for light wavelength of 530 nm is treated as zero.

In this simulation, with regard to the structural model defined by the first column in TABLE 1, the first electrode is of Al, the light emission layer is of a polymer material with electron transport properties, the hole injection layer is of PEDOT, the second electrode is of ITO, and the hemispherical lens is of glass. The matching oil of the structural model defined by the first column in TABLE 1 has the refractive index similar to the refractive index of the glass used for the hemispherical lens. However, the thickness of the matching oil is 1 nm or less, and is extremely thin relative to the hemispherical lens and the second electrode. Hence, the matching oil is not considered. The thickness of the hemispherical lens is treated as infinity. Further, the light emission layer has the electron transport properties and PEDOT has hole transport properties, and therefore a position of light emission is supposed to be an interface between the light emission layer and the hole injection layer.

In this simulation, first, calculation was conducted for an electric field component (electric filed component of a TE mode) oscillating in the in-plane direction inside the light emission layer and another electric field component (electric field component of a TM mode) oscillating in the thickness direction inside the light emission layer. In this regard, to consider birefringence, the refractive index in the in-plane direction was used for calculation of the electric field component of the TE mode, and the refractive index in the thickness direction was used for calculation of the electric field component of the TM mode.

Thereafter, the electric field component of the TE mode and the electric field component of the TM mode were converted into an s-polarization component and a p-polarization component, respectively. Subsequently, an average of the s-polarization component and the p-polarization component was calculated, and then radiant flux proportional to the external quantum efficiency was calculated in view of a solid angle.

TABLE 2 shows the relative quantum efficiency that means a relative value indicative of the radiant flux normalized such that the radiant flux corresponding to the ratio of the refractive index in the in-plane direction of the light emission layer to the refractive index in the thickness direction of the light emission layer being 1.05 is equal to 1.

FIG. 2 shows a graph that has a horizontal axis representing the ratio of the refractive index in the in-plane direction to the refractive index in the thickness direction and a vertical axis representing the relative external quantum efficiency shown in TABLE 2. The light-outcoupling efficiency of the structural model is proportional to the external quantum efficiency and increases with an increase in the external quantum efficiency.

The result in FIG. 2 shows that the ratio of the refractive index in the in-plane direction of the light emission layer 31 to the refractive index in the thickness direction of the light emission layer 31 is preferably 1.1 or more in the organic electroluminescent element. According to this condition, it is considered that the light-outcoupling efficiency of the organic electroluminescent element can be improved more successfully.

The result in FIG. 2 also shows that the ratio of the refractive index in the in-plane direction of the light emission layer 31 to the refractive index in the thickness direction of the light emission layer 31 is preferably 1.2 or more in the organic electroluminescent element. According to this condition, it is possible to more improve the light-outcoupling efficiency of the organic electroluminescent element.

Further, in the organic electroluminescent element, it is preferable that the ratio of the refractive index in the in-plane direction of the light emission layer 31 to the refractive index in the thickness direction of the light emission layer 31 be 1.4 or more. According to this condition, it is possible to drastically improve the light-outcoupling efficiency of the organic electroluminescent element, and also possible to reduce a variation of the light-outcoupling efficiency caused by change in the ratio of the refractive index. Thus, variations between the light-outcoupling efficiencies of individual products can be reduced. Hence, selection and design of the polymer material of the light emission layer 31 of the organic electroluminescent element is more flexible.

In measurement of the refractive index in the in-plane direction and the refractive index in the thickness direction of the light emission layer 31, an amplitude ratio ψ and a phase difference Δ with regard to the p-polarization component and the s-polarization component, that are ellipsometry parameters, were measured with a spectroscopic ellipsometer (trade name "FE-5000S" available from OTSUKA ELECTRONICS co., ltd.), and the refractive index in the in-plane direction and the refractive index in the thickness direction of the light emission layer 31 were calculated based on an analysis based on the Tauc-Lorentz equation using a uniaxial anisotropic optical model. In this regard, a measurement sample used in the above measurement was prepared by applying the polymer material on a glass substrate with a spin coater and then heating the applied polymer material at 150°C for 10 minutes. With regard to conditions for the measurement, an incident angle is 70° and a wavelength of light is in a range of 300 to 800 nm. Note that, the incident angle is not limited to 70° as long as total reflection of the incident light is successfully caused.

Note that, molecular orientation of the thin film of the light emission layer 31 made of the polymer material can be confirmed by a spectroscopic analysis disclosed in JP 4340814 B2.

The above light emission layer 31 is probably made of a polymer material such that a dipole moment in horizontal orientation along the in-plane direction of the light emission layer 31 is greater than a dipole moment in vertical orientation along the thickness direction of the light emission layer 31.

The method of manufacturing the above organic electroluminescent element is described below.

First, the first electrode 20 is formed on the surface of the substrate 10. The method of forming the first electrode 20 may be selected from a dry process and a wet process in accordance with the material of the first electrode 20. Examples of the dry process include vacuum deposition, sputtering, and laminating conducted by thermocompression bonding of metal thin films. For example, the wet process may be coating such as spin coating, casting, micro gravure printing, gravure printing, die coating, bar coating, roll coating, wire bar coating, dip coating, spray coating, screen printing, flexography, offset printing, and inkjet printing. The first electrode 20 serves as a base layer for the functional layer 30 and therefore preferably has the decreased surface roughness. The dry process can provide a surface smoother than a surface provided by the wet process and therefore the first electrode 20 is preferably formed by the dry process.

After the first electrode 20 is formed on the surface of the substrate 10 in the above manner, the functional layer 30 is formed over the surface of the substrate 10 (in the present embodiment, on the surface of the first electrode 20). The method of forming the functional layer 30 may be selected from various types of formation methods in consideration with the material of the functional layer 30, and for example may be the wet process described above. In the functional layer 30, the light emission layer 31, the hole transport layer 32, and the hole injection layer 33 are formed sequentially in this order.

Forming the layers of the functional layer 30 (in the instance shown in FIG. 1, the light emission layer 31, the hole transport layer 32, and the hole injection layer 33) by the wet process (e.g., coating) may cause some problems. For example, a layer serving as a base is likely to be dissolved by a coating solution, the coating solution is not likely to be spread evenly, and wettability is low. According to a formation order of the layers (the hole injection layer 103, the hole transport layer 104, the organic light emission layer 105, the electron transport layer 106, and the electron injection layer 107) of the functional layer of the organic electroluminescent element illustrated in FIG. 6, the above problems may not occur. However, according to a structure that needs to be formed in accordance with substantially the same formation order as the functional layer 30 of the present embodiment, in some cases the above problems occur remarkably. For example, solutions to the problem that the layer serving as the base is dissolved by the coating solution may include: using a different solvent for the layer serving as the base from a solvent for the coating solution; using the layer serving as the base having a cross-linked structure in the case where the same solvent is used for the layer serving as the base and the coating solution; and forming the layer serving as the base such that the thickness of the layer is greater than the desired thickness of the layer in consideration with a decrease in the thickness of the layer caused by dissolution of the layer due to the coating solution for the next layer. For example, solutions to the problem that the coating solution is not spread evenly may include accelerating the drying speed and changing the solvent. For example, to solve the problem that the wettability is low, a solvent (e.g., alcohol) for improving the wettability may be added to the coating solution to improve the wettability.

After the functional layer 30 is formed over the surface of the substrate 10 in the above manner, the second electrode 40 is formed over the surface of the substrate 10 (in the present embodiment, on the surface on the opposite side of the functional layer 30 from the first electrode 20). Preferably, the second electrode 40 is formed by the wet process. The wet process does not require expensive film formation apparatus such as sputtering equipment and deposition equipment and therefore the production cost can be lowered.

Note that, with regard to the method of manufacturing the organic electroluminescent element with the structure illustrated in FIG. 6, the transparent electrode 102 that is a light transmissive electrode may be formed by the wet process. In this regard, to prevent a short circuit between the transparent electrode 102 and the metal electrode 108, it is necessary to decrease the surface roughness of the transparent electrode 102. Further, with regard to the transparent electrode 102 formed by the wet process, to achieve desired purposes such as defining the emission area and preventing a short circuit between the transparent electrode 102 and the metal electrode 108, to pattern the transparent electrode 102 is necessary. Examples of patterning the transparent electrode 102 may include patterning by forming banks after film formation, patterning by etching, and patterning by printing. However, patterning such as patterning by forming banks and patterning by etching requires applying a resist, immersing the resist in a developer, and immersing the resist in a resist remover. Hence, the transparent electrode 102 is likely to be damaged, and there is a probability that properties for acting as the light-transmissive electrode are deteriorated. In contrast, with regard to the pattering by printing, for example, when screen printing is used, there is a high probability that a mesh screen forms recesses and protrusions at the surface of the transparent electrode 102. When gravure printing or slit die coating is used, the thickness of the transparent electrode 102 at start of the application is likely to be different from the thickness of the transparent electrode 102 at end of the application and therefore level differences may occur at the surface of the transparent electrode 102. The above recesses and protrusions and level differences at the surface of the transparent electrode 102 may cause a short circuit between the metal electrode 108 and the transparent electrode 102. With regard to the printing, leveling after the application is facilitated by using a printing ink with a low viscosity. Therefore, it is possible to lower the surface roughness of the transparent electrode 102. However, a decrease in the viscosity causes a rise in difficultly of increasing the thickness. Note that, when an electrically conductive polymer material such as highly conductive PEDOT-PSS used generally and frequently is used as the material of the light-transmissive electrode formed by the wet process, the transparent electrode 102 is required to have a thickness in a range of about 500 to 1000 nm in order to have electrical conductivity to the same extent as electrical conductivity of a transparent conductive film of an ITO with a thickness in a range of 100 to 200 nm. Hence, when the above electrically conductive polymer material is used as the material of the light-transmissive electrode, it is difficult to decrease the viscosity of the printing ink. Alternatively, when a material higher in electrical conductivity than the above highly conductive PEDOT-PSS is used as the material of the light-transmissive electrode, the thickness of the light-transmissive electrode can be decreased. Therefore, a decrease in the viscosity of the printing ink does not cause any problem with regard to ensuring the thickness sufficient for realizing the desired electrical conductivity. However, such a decrease in the viscosity is likely to cause other problems such as deterioration of the wettability for the base and occurrence of blurring. Hence, it is not easy to form the stable light-transmissive electrode.

Whereas, as shown in FIG. 1, the organic electroluminescent element of the present embodiment has the laminated structure in which the second electrode 40 serving as the light-transmissive electrode is formed after formation of the functional layer 30. Hence, a short circuit can be suppressed and thus the reliability is improved. Additionally, with regard to the method of manufacturing the organic electroluminescent element of the present embodiment, for example, the substrate 10 is flexible and the layers (in the instance shown in FIG. 1, the light emission layer 31, the hole transport layer 32, the hole injection layer 33, and the second electrode 40) are formed by coating using the roll-to-roll manner. Hence, the production cost can be lowered.

The organic electroluminescent element of the present embodiment described above includes: the first electrode 20 of the metal electrode; the second electrode 40 opposite the first electrode 20; and the functional layer 30 that is between the first electrode 20 and the second electrode 40 and has at least the light emission layer 31. The organic electroluminescent element is configured to allow light to emerge outside from the second electrode 40. Further in the organic electroluminescent element of the present embodiment, the light emission layer 31 is formed of the polymer material to have such characteristics that the refractive index in the in-plane direction of the light emission layer 31 is greater than the refractive index in the thickness direction of the light emission layer 31. Therefore, with regard to the organic electroluminescent element, it is considered that the light emission layer 31 is of the polymer material such that the dipole moment in the horizontal orientation along the in-plane direction of the light emission layer 31 is greater than the dipole moment in the vertical orientation along the thickness direction of the light emission layer 31. Hence, it is considered that when the organic electroluminescent element of the present embodiment emits light, it is possible to reduce an amount of light causing the surface plasmon and the dipole in the vertical direction emitting a high angle component of light (also referred to as thin film waveguide light or light of a waveguide mode inside the element) that is to be lost inside the element. In this regard, the high angle component of light is defined as a component of light that is emitted from a light emission point at a greater angle relative to a straight line passing through the light emission point in the thickness direction of the light emission layer 31 and therefore is totally reflected at an interface between the light emission layer 31 and the second electrode 40.

According to the organic electroluminescent element of the present embodiment, the light emission layer 31 is formed of the polymer material to have such characteristics that the refractive index in the in-plane direction of the light emission layer 31 is greater than the refractive index in the thickness direction of the light emission layer 31. Hence, it is possible to improve the light-outcoupling efficiency yet the structure is simplified. This seems to be because the light emission layer 31 of the organic electroluminescent element of the present embodiment is made of such a polymer material that the dipole moment in the horizontal orientation is greater than the dipole moment in the vertical orientation. According to this, it is considered that it is possible to reduce optical loss caused by the surface plasmon on the surface of the metal electrode constituting the first electrode 20 and also reduce optical loss caused by the waveguide component of light inside the functional layer 30, and consequently the light-outcoupling efficiency can be improved.

Further, in the organic electroluminescent element of the present embodiment, the light emission layer 31 may be formed such that the ratio of the refractive index in the in-plane direction of the light emission layer 31 to the refractive index in the thickness direction of the light emission layer 31 is greater than 1.05 and is 2.5 or less. Also in this case, as described above, emission molecules of the polymer material are oriented horizontally, and the horizontal dipole moment is greater than the vertical dipole moment. Hence, the light-outcoupling efficiency can be improved.

### (SECOND EMBODIMENT)

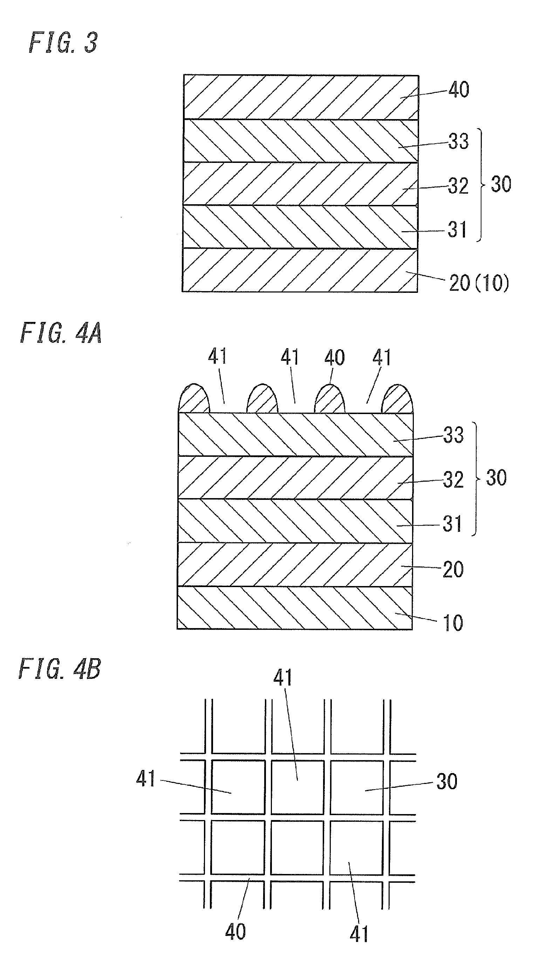

As shown in FIG. 3, the organic electroluminescent element of the present embodiment has substantially the same structure as the first embodiment, but is different from the first embodiment in that the first electrode 20 serves as the substrate 10 described in the first embodiment. Note that, components of the present embodiment that are the same as those of the first embodiment are not described below.

In the organic electroluminescent element of the present embodiment, the first electrode 20 defining the metal electrode serves as the substrate 10 for supporting the laminate of the functional layer 30 and the second electrode 40. Thus, the production cost can be lowered. Additionally, when the first electrode 20 is made of metal foil, it is possible to achieve a sealing performance same as that of the structure of the first embodiment in which the substrate 10 is of a barrier film including a plastic plate and a gas barrier layer on the plastic plate, but the production cost can be lowered.

### (THIRD EMBODIMENT)

As shown in FIG. 4A, the organic electroluminescent element of the present embodiment has substantially the same structure as the first embodiment, but is different from the first embodiment in that the second electrode 40 has a mesh shape (net-like shape). Note that, components of the present embodiment that are the same as those of the first embodiment are not described below.

Although the second electrode 40 can be made of the above electrically conductive material, the second electrode 40 can be an appropriate arrangement of a plurality of narrow line parts individually defined by a plurality of narrow members made of metal such as silver and copper or another electrically conductive material such as carbon black, for example. For example, each of the narrow line parts of the second electrode 40 having the mesh shape may have a width in a range of about 1 to 100 µm, but the width is not limited to a particular one. Additionally, pitches between the narrow line parts, and heights of the individual narrow line parts in the thickness direction of the functional layer 30 both may be selected appropriately. Alternatively, the second electrode 40 with the mesh shape may be formed by applying an electrically conductive paste including the above electrically conductive material by screen printing. Note that, the method of forming the second electrode 40 is not limited to the above options.

The second electrode 40 with the mesh shape includes spaces (openings) 41 each having an appropriate shape in a plan view. For example, as shown in FIG. 4B, the second electrode 40 with the mesh shape may have a grid structure (lattice structure), and the shape of the space 41 in the plan view may be rectangular or square. Alternatively, the shape of the space 41 in the plan view may be triangular, hexagonal, circular, or any shape.

The organic electroluminescent element of the present embodiment allows light emitted from the light emission layer 31 to emerge outside through the spaces 41 of the second electrode 40. In brief, in the organic electroluminescent element, the second electrode 40 includes a plurality of spaces 41 individually serving as a plurality of openings allowing light from the functional layer 30 to pass. In this regard, the second electrode 40 of the organic electroluminescent element of the present embodiment can be lower in the resistivity and the sheet resistance than the second electrode 40 that is a thin film of transparent conducting oxide (TCO). Hence, the resistance of the second electrode 40 can be lowered, and therefore luminance unevenness can be reduced. Note that, examples of the transparent conducting oxide may include ITO, AZO, GZO, and IZO, for example.

Additionally, in the organic electroluminescent element of the present embodiment, it is preferable that the electrically conductive polymer layer be formed on an uppermost layer (in this instance, the hole injection layer 33) of the functional layer 30 and the second electrode 40 having the mesh shape be formed on this electrically conductive polymer layer.

### (FOURTH EMBODIMENT)

As shown in FIG. 5, the organic electroluminescent element of the present embodiment has substantially the same structure as the third embodiment, but is different from the third embodiment in that the first electrode 20 serves as the substrate 10 described in the third embodiment. Note that, components of the present embodiment that are the same as those of the third embodiment are not described below.

In the organic electroluminescent element of the present embodiment, the first electrode 20 defining the metal electrode serves as the substrate 10 for supporting the laminate of the functional layer 30 and the second electrode 40. Thus, the production cost can be lowered. Additionally, when the first electrode 20 is made of metal foil, it is possible to achieve a sealing performance same as that of the structure of the third embodiment in which the substrate 10 is of a barrier film including a plastic plate and a gas barrier layer on the plastic plate, but the production cost can be lowered.

The organic electroluminescent elements described in the individual embodiments are preferably available, for example, for organic electroluminescent elements for lighting use. However, the organic electroluminescent elements are available for not only lighting use but also other use (e.g., displays, backlights, and indicators).

Note that, FIGs used for describing the individual embodiments are schematic, and do not necessarily show actual ratios of dimensions (e.g., lengths and thicknesses) to other dimensions of the components.

### EXAMPLES

### (EXAMPLE 1)

According to EXAMPLE 1, an organic electroluminescent element was prepared based on the structure illustrated in FIG. 1. In this organic electroluminescent element, the substrate 10 has the thickness of 0.7 mm, the first electrode 20 has the thickness of 80 nm, the light emission layer 31 has the thickness of 80 nm, the hole injection layer 33 has the thickness of 15 nm, and the second electrode 40 has the thickness of 300 nm.

In EXAMPLE 1, the substrate 10 was made of a non-alkali glass substrate (trade name "1737" available from Corning Incorporated). The first electrode 20 was made of aluminum. The light emission layer 31 was made of polymer fluorescent substance 1 (hereinafter referred to as polymer material 1) disclosed in JP 2003-147347 A. The hole injection layer 33 was made of PEDOT-PSS. The second electrode 40 was made of ITO nano-particles with an average particle size of 40 nm (trade name "NanoTek (registered trademark) ITCW 15wt%-G30" available from C. I. KASEI co., ltd.).

The method of manufacturing the organic electroluminescent element of the present example is described below.

First, the first electrode 20 of an aluminum film having the thickness of 80 nm was formed on the surface of the substrate 10 by vacuum deposition. Thereafter, a solution, which was prepared by dissolving the polymer material 1 serving as the material of the light emission layer 31 into a xylene solvent such that the percentage of the polymer material 1 to the solution was 1.3 wt%, was applied over the surface of the substrate 10 with a spin coater to form a layer with the thickness of about 80 nm on the first electrode 20, and then the resultant layer was heated at 130°C for 10 minutes to give the light emission layer 31. Subsequently, a solution, which was prepared by mixing PEDOT-PSS with isopropyl alcohol such that a ratio of the PEDOT-PSS to the isopropyl alcohol was 1:1, was applied over the surface of the substrate 10 with a spin coater to form a layer with the thickness of 15 nm on the polymer material 1, and then the resultant layer was heated at 150°C for 10 minutes to give the hole injection layer 33. After that, a solution, which was prepared by mixing methyl cellulose (trade name "METOLOSE (registered trademark) 60SH" available from Shin-Etsu Chemical co., ltd.) with ITO nano-particles with the average particle size of 40 nm such that the percentage of the methyl cellulose to the solution was 5 wt%, was applied over the surface of the substrate 10 (in this instance, on the hole injection layer 33) with a screen printer to form a patterned layer with the thickness of about 300 nm, and then the patterned layer was dried at 120°C for 15 minutes to give the second electrode 40.

### (EXAMPLE 2)

According to EXAMPLE 2, an organic electroluminescent element was prepared based on the structure illustrated in FIG. 3. In this organic electroluminescent element, the first electrode 20 has the thickness of 30 µm, the light emission layer 31 has the thickness of 80 nm, the hole injection layer 33 has the thickness of 15 nm, and the second electrode 40 has the thickness of 300 nm.

In this regard, in EXAMPLE 2, the first electrode 20 was made of aluminum foil with the thickness of 30 µm. The materials, thicknesses, and formation methods of the light emission layer 31, the hole injection layer 33, and the second electrode 40 were the same as those of EXAMPLE 1.

### (EXAMPLE 3)

According to EXAMPLE 3, an organic electroluminescent element was prepared based on the structure illustrated in FIG. 4A. In this organic electroluminescent element, the substrate 10 has the thickness of 0.7 mm, the first electrode 20 has the thickness of 80 nm, the light emission layer 31 has the thickness of 80 nm, and the hole injection layer 33 has the thickness of 15 nm. This organic electroluminescent element further includes an electrically conductive polymer layer that is between the hole injection layer 33 and the second electrode 40 and has the thickness of 200 nm. The second electrode 40 has such a mesh shape that the widths of the narrow line parts are 40 µm, the pitches between centers of the individual narrow line parts are 1000 µm, and the heights of the narrow line parts are about 5 µm.

In EXAMPLE 3, the substrate 10 was made of a non-alkali glass substrate (trade name "1737" available from Corning Incorporated). The materials, thicknesses, and formation methods of the first electrode 20, the light emission layer 31, and the hole injection layer 33 were the same as those of EXAMPLE 1. The electrically conductive polymer layer was of highly conductive PEDOT-PSS. Further, the second electrode 40 was made of silver paste.

The electrically conductive polymer layer was formed as follows: the highly conductive PEDOT-PSS was applied over the surface of the substrate 10 (in this instance, on the hole injection layer 33,) to form the electrically conductive polymer layer having the thickness of 200 nm. Additionally, the second electrode 40 was formed as follows: the second electrode 40 with the mesh shape illustrated in FIG. 4A and FIG. 4B was formed over the surface of the substrate 10 (in this instance, on the electrically conductive polymer layer) with a screen printer.

### (EXAMPLE 4)

According to EXAMPLE 4, an organic electroluminescent element was prepared based on the structure illustrated in FIG. 5. In this organic electroluminescent element, the first electrode 20 has the thickness of 30 µm, the light emission layer 31 has the thickness of 80 nm, and the hole injection layer 33 has the thickness of 15 nm. This organic electroluminescent element further includes an electrically conductive polymer layer that is between the hole injection layer 33 and the second electrode 40 and has the thickness of 200 nm. The second electrode 40 has such a mesh shape that the widths of the narrow line parts are 40 µm, the pitches between centers of the individual narrow line parts are 1000 µm, and the heights of the narrow line parts are about 5 µm.

In this regard, in EXAMPLE 4, the first electrode 20 was made of aluminum foil with the thickness of 30 µm. The materials, thicknesses, and formation methods of the light emission layer 31, the hole injection layer 33, the electrically conductive polymer layer, and the second electrode 40 were the same as those of EXAMPLE 3.

### (COMPARATIVE EXAMPLE 1)

The organic electroluminescent element prepared as COMPARATIVE EXAMPLE 1 was different from EXAMPLE 1 only in the material of the light emission layer 31. In this regard, the light emission layer 31 was formed as follows: a solution, which was prepared by dissolving a polymer material (trade name "Green1302" available from Sumitomo Chemical co., ltd.) into a xylene solvent such that the percentage of the polymer material to the solution was 1.3 wt%, was applied over the surface of the substrate 10 (in this instance, on the first electrode 20) with a spin coater to form a layer with the thickness of 80 nm, and then the resultant layer was heated at 130°C for 10 minutes to give the light emission layer 31.

### (COMPARATIVE EXAMPLE 2)

The organic electroluminescent element prepared as COMPARATIVE EXAMPLE 2 was different from EXAMPLE 2 only in the material of the light emission layer 31. In this regard, the light emission layer 31 was formed as follows: a solution, which was prepared by dissolving a polymer material (trade name "Green1302" available from Sumitomo Chemical co., ltd.) into a xylene solvent such that the percentage of the polymer material to the solution was 1.3 wt%, was applied on the first electrode 20 with a spin coater to form a layer with the thickness of 80 nm, and then the resultant layer was heated at 130°C for 10 minutes to give the light emission layer 31.

### (COMPARATIVE EXAMPLE 3)

The organic electroluminescent element prepared as COMPARATIVE EXAMPLE 3 was different from EXAMPLE 3 only in the material of the light emission layer 31. In this regard, the light emission layer 31 was formed as follows: a solution, which was prepared by dissolving a polymer material (trade name "Green1302" available from Sumitomo Chemical co., ltd.) into a xylene solvent such that the percentage of the polymer material to the solution was 1.3 wt%, was applied over the surface of the substrate 10 (in this instance, on the first electrode 20) with a spin coater to form a layer with the thickness of 80 nm, and then the resultant layer was heated at 130°C for 10 minutes to give the light emission layer 31.

### (COMPARATIVE EXAMPLE 4)

The organic electroluminescent element prepared as COMPARATIVE EXAMPLE 4 was different from EXAMPLE 4 only in the material of the light emission layer 31. In this regard, the light emission layer 31 was formed as follows: a solution, which was prepared by dissolving a polymer material (trade name "Green1302" available from Sumitomo Chemical co., ltd.) into a xylene solvent such that the percentage of the polymer material to the solution was 1.3 wt%, was applied on the first electrode 20 with a spin coater to form a layer with the thickness of 80 nm, and then the resultant layer was heated at 130°C for 10 minutes to give the light emission layer 31.

The polymer material used in the organic electroluminescent elements of individual EXAMPLES and the polymer material used in the organic electroluminescent elements of individual COMPARATIVE EXAMPLES were applied on individual glass substrates under the same condition described above, and then heated at 130°C for 10 minutes to give individual layers as samples of the former and latter polymer materials. With regard to each sample, measurement with a spectroscopic ellipsometer (trade name "FE-5000S" available from OTSUKA ELECTRONICS co., ltd.) was conducted to determine the ratio of the refractive index in the in-plane direction to the refractive index in the thickness direction. The ratios of the individual samples are shown in TABLE 3. Note that, the wavelength of 530 nm is an emission peak wavelength of light caused by the polymer material ("Green1302") used in each COMPARATIVE EXAMPLE. TABLE 3 shows that the polymer material 1 used in each of EXAMPLES 1 to 4 gives the ratio of the refractive index in the in-plane direction to the refractive index in the thickness direction that is greater than that given by the polymer material ("Green1302") used in each of COMPARATIVE EXAMPLES 1 to 4.

**[TABLE 3]**

| Names of polymer materials | Polymer material 1 | Green 1302 |
|---|---|---|
| Refractive index in thickness direction (wavelength of 530 nm) | 1.47 | 1.64 |
| Refractive index in in-plane direction (wavelength of 530 nm) | 1.69 | 1.72 |
| Ratio of refractive index in in-plane direction to refractive index in thickness direction | 1.15 | 1.05 |

Measurement of the external quantum efficiencies of the organic electroluminescent elements of EXAMPLES 1 to 4 and COMPARATIVE EXAMPLES 1 to 4 was conducted. In this measurement, hemispherical lenses of glass were situated on the light emission surfaces of the above organic electroluminescent elements while matching oils were between the hemispherical lenses and the light emission surfaces. TABLE 4 shown below provides the result of the measurement. TABLE 4 shows relative values of the external quantum efficiencies of the organic electroluminescent elements of EXAMPLES 1 to 4 and COMPARATIVE EXAMPLES 1 to 4 to the external quantum efficiency of the organic electroluminescent element of COMPARATIVE EXAMPLE 1 being 1.0. In short, TABLE 4 shows the relative external quantum efficiencies. In the measurement of the external quantum efficiencies, a DC power supply (trade name "2400" available from Keithley Instruments, Inc.) was used to supply a constant current with a current density of 10 mA/cm² to the organic electroluminescent elements of EXAMPLES 1 to 4 and COMPARATIVE EXAMPLES 1 to 4, and luminance of an angle in a range of -80° to +80° at intervals of 10° was measured with a luminance meter (trade name "SR-3" available from Topcon corporation) for each of the organic electroluminescent elements of EXAMPLES 1 to 4 and COMPARATIVE EXAMPLES 1 to 4, and the external quantum efficiencies were calculated based on the measurement results.

**[TABLE 4]**

| | External quantum efficiency |
|---|---|
| Comparative example 1 | 1.0 |
| Comparative example 2 | 1.0 |
| Comparative example 3 | 1.01 |
| Comparative example 4 | 1.01 |
| Example 1 | 1.13 |
| Example 2 | 1.13 |
| Example 3 | 1.14 |
| Example 4 | 1.14 |

TABLE 4 shows that the organic electroluminescent elements of EXAMPLES 1 to 4 are greater in the external quantum efficiency than the organic electroluminescent elements of COMPARATIVE EXAMPLES 1 to 4. Further, TABLES 2 to 4 show that the ratio of the refractive index in the in-plane direction to the refractive index in the thickness direction of the organic electroluminescent element of EXAMPLE 1 is substantially the same as the corresponding simulation result. Hence, it is considered that the result of the above simulation is reasonable.

## Claims

1. An organic electroluminescent element comprising an invert structure including:
a first electrode of a metal electrode;
a second electrode opposite the first electrode; and
a functional layer that is between the first electrode and the second electrode and includes at least a light emission layer,
the light emission layer that is of a polymer material, and has an in-plane direction and a thickness direction,
a refractive index in the in-plane direction of the light emission layer being greater than a refractive index in the thickness direction of the light emission layer,
the first electrode being a cathode, and
the second electrode being an anode.

2. The organic electroluminescent element according to claim 1, wherein
a ratio of the refractive index in the in-plane direction of the light emission layer to the refractive index in the thickness direction of the light emission layer is greater than 1.05.

3. The organic electroluminescent element according to claim 2, wherein
the ratio is 1.1 or more.

4. The organic electroluminescent element according to claim 3, wherein
the ratio is 1.2 or more.

5. The organic electroluminescent element according to claim 3, wherein
the ratio is 1.4 or more.

6. The organic electroluminescent element according to any one of claims 2 to 5, wherein
the ratio is 2.5 or less.

7. The organic electroluminescent element according to any one of claims 1 to 6, wherein
the metal electrode serves as a substrate supporting a laminate of the functional layer and the second electrode.

8. The organic electroluminescent element according to any one of claims 1 to 7, wherein
the second electrode has a mesh shape.
